# EUROPÄISCHE PATENTSCHRIFT

(11) **EP 4 310 432 B1**
(45) Veröffentlichungstag und Bekanntmachung des Hinweises auf die Patenterteilung: **13.05.2026**
(21) Anmeldenummer: 23183576.0
(22) Anmeldetag: 05.07.2023
(51) Int. Cl.: F28F 9/02, F28F 9/26, F28F 21/06, F28F 21/08

(54) **KÜHLBAUTEIL UND VERFAHREN ZUR HERSTELLUNG DESSELBEN**
COOLING COMPONENT AND METHOD FOR PRODUCING THE SAME
COMPOSANT DE REFROIDISSEMENT ET SON PROCÉDÉ DE FABRICATION

(30) Priorität: 18.07.2022 DE 102022117863; 09.06.2023 DE 102023115116
(43) Veröffentlichungstag der Anmeldung: 24.01.2024
(60) Teilanmeldung: 24174016.6
(73) Patentinhaber: Erwin Quarder Systemtechnik GmbH, 32339 Espelkamp (DE)
(72) Erfinder: Heitbrink, Alexander, 32351 Stemwede (DE); Siewert, Georg, 35415 Pohlheim (DE)
(74) Vertreter: Geskes, Christoph

(56) Entgegenhaltungen:
- EP-A1- 3 885 689
- DE-A1- 102016 125 859
- US-A1- 2014 090 812
- US-A1- 2017 343 144

## Beschreibung

Die Erfindung betrifft ein Verfahren zur Herstellung eines Kühlbauteils mit einem insbesondere länglichen, vorzugsweise beschichteten Kühlkörper aus Metall oder aus einer Metalllegierung, insbesondere Aluminium, mit dem ein Gegenstand gekühlt werden kann, wobei der Kühlkörper über ein oder mehrere, vorzugsweise parallele, insbesondere längliche und/oder geradlinige Mediumkanäle zum Durchfluss von Kühlmedium verfügt, und mit einem mit dem Kühlkörper fluiddicht verbundenen Anschlussteil, über das dem Kühlkörper das Kühlmedium zuführbar ist und/oder über das von dem Kühlkörper das Kühlmedium abführbar ist.

Kühlbauteile zum Abführen von Wärme von zu kühlenden Gegenständen werden auch als Wärmetauscher bezeichnet und in vielen Bereichen der Technik eingesetzt. Besondere Bedeutung kommt solchen Kühlbauteilen unter anderem bei der Kühlung von Batterie- bzw. Akkumulatorensystemen für Elektrofahrzeuge zu, aber auch von Leistungselektronikbauteilen, von Busbars oder von Prozessorchips. Die eingangs genannten Kühlbauteile sind dabei in der Regel Bestandteil einer übergeordneten Kühleinrichtung, die dafür sorgt, dass Kühlmedium, wie etwa Wasser oder dergleichen, kontinuierlich durch das Kühlbauteil geführt wird.

Die Kühlkörper, die im Betrieb in der Regel an dem zu kühlenden Gegenstand anliegen, zumindest aber in der unmittelbaren Nähe desselben angeordnet sind, sind häufig aus einzelnen Bauteilen aus Metall oder einer Metalllegierung (bspw. Stahl) hergestellt, indem diese aufwändig miteinander verschweißt oder verlötet sind. Das mit dem Kühlkörper verbundene Anschlussteil zum Zu- und/oder Abführen von Kühlmedium besteht dabei häufig aus demselben Metall bzw. aus derselben Metalllegierung wie der Kühlkörper und ist mit diesem ebenfalls aufwändig verschweißt oder verlötet. Da solche Anschlussteile in der Regel allerdings nicht für die unmittelbare Wärmeübertragung von dem zu kühlenden Gegenstand auf das Kühlbauteil gedacht sind, wäre es eigentlich nicht erforderlich, auch die Anschlussteile aus hochwärmeleitendem, metallischem Material herzustellen. Dies ist funktional sogar eher kontraproduktiv.
DE 10 2016 125859 A1 offenbart eine flexible Anbindung eines metallischen Strangpressprofils an einen Anschlusskörper zur Verwendung in Kühlanwendungen für elektrische Komponenten. US 2014/090812 A1 offenbart einen Wärmetauscher mit einem ersten Sammelkasten und mit einem zweiten Sammelkasten, mit mindestens einem zwischen den beiden Sammelkästen angeordneten Rohr, wobei ein Fluideinlass und ein Fluidauslass vorgesehen sind, die einzeln an jeweils einem der Sammelkästen oder an einem einzigen der Sammelkästen angeordnet sind.

Es ist Aufgabe der vorliegenden Erfindung, ein Verfahren zur Herstellung eines eingangs genannten weiterentwickelten Kühlbauteils anzugeben.

Diese Aufgabe wird gelöst durch ein Herstellungsverfahren mit den Merkmalen des Anspruchs 1.

Mit dem erfindungsgemäßen Verfahren wird ein Kühlbauteil hergestellt, wobei das Anschlussteil aus Kunststoff besteht (bevorzugt ausgebildet als Kunststoff-Spritzgussteil), wobei zur Verbindung des Anschlussteils mit dem vorzugsweise aus Aluminium hergestellten bzw. bestehenden Kühlkörper ein erster, insbesondere endständiger Verbindungsbereich des Kühlkörpers in den Aufnahmeraum einer Aufnahme des Anschlussteils eingebracht ist und dort mit der Aufnahme fluiddicht verbunden ist, der mehrere Verbindungsflächen aufweist mit jeweils insbesondere durch physikalische und/oder chemische Nano- oder Mikrostrukturierungsverfahren eingebrachten, dreidimensionalen Nano- und/oder Mikrostrukturen. Dabei ist der Verbindungsbereich des Kühlkörpers mit der Aufnahme fluiddicht verbunden, indem jede Verbindungsfläche des Kühlkörpers jeweils einer zugeordneten Verbindungsfläche der Aufnahme gegenüberliegt und mit dieser (unter thermischer Direktfügung) verpresst ist.

Das erfindungsgemäße Verfahren zur Herstellung eines solchen Kühlbauteils umfasst erfindungsgemäß folgende Maßnahmen:
a) Einführen eines bzw. des insbesondere endständigen Verbindungsbereichs eines/des vorgefertigten, insbesondere durch Profilextrusion hergestellten, insbesondere einstückig gefertigten oder einstückig ausgebildeten Kühlkörpers in den Aufnahmeraum einer Aufnahme eines/des vorgefertigten, insbesondere spritzgegossenen Anschlussteils aus Kunststoff für den Kühlkörper mittels Relativbewegung zwischen Kühlkörper und Anschlussteil, sodass jede von mehreren, sich jeweils insbesondere parallel gegenüberliegenden Verbindungsflächen des Verbindungsbereichs des Kühlkörpers mit jeweils insbesondere durch physikalische und/oder chemische Nano- oder Mikrostrukturierungsverfahren eingebrachten, dreidimensionalen Nano- und/oder Mikrostrukturen, jeweils einer zugeordneten Verbindungsfläche der Aufnahme des Anschlussteils gegenüberliegt, insbesondere einer jeweils zugeordneten Verbindungsfläche, die an einer Innenseite einer Wandung der Aufnahme angeordnet ist,
b) Erwärmen der Verbindungsflächen des Kühlkörpers, insbesondere mittels Induktion, auf eine Temperatur, die mindestens der Schmelztemperatur des Kunststoffs des Anschlussteils entspricht, insbesondere bevor der Verbindungsbereich des Kühlkörpers in den Aufnahmeraum der Aufnahme eingeführt wird und/oder während sich der Verbindungsbereich in dem Aufnahmeraum befindet,
c) fluiddichtes Verbinden von allen erwärmten Verbindungsflächen des Kühlkörpers mit der jeweils gegenüberliegenden Verbindungsfläche des Anschlussteils durch Verpressen dieser sich gegenüberliegenden Verbindungsflächen unter Aufschmelzen der Verbindungsfläche des Anschlussteils durch die Wärme der Verbindungsfläche des Kühlkörpers.

Die Verwendung eines Anschlussteils aus Kunststoff ist zum einen deutlich kostengünstiger als die Verwendung eines Anschlussteils aus Metall bzw. Metalllegierungen und zum anderen kann die vergleichsweise geringe Wärmeleitfähigkeit von Kunststoff in diesem Zusammenhang funktional vorteilhaft sein, um beispielsweise einen ungewollten Wärme-übertrag auf das Kühlmedium im Bereich des Anschlussteils zu verhindern.

Da das Kunststoffteil eine Aufnahme mit Aufnahmeraum für den Kühlkörper aufweist bzw. für einen Verbindungsbereich desselben, kann durch die thermische Direktfügung unter Verwendung der Nano- und Mikrostrukturen im Rahmen eines vorteilhaften, insbesondere positionsgenauen Herstellungsprozesses eine stabile und fluiddichte Verbindung zwischen dem metallischen Kühlkörper - unter "metallisch" werden im Rahmen der Anmeldung der Einfachheit halber sowohl Metalle als auch Metalllegierungen gefasst - und dem Anschlussteil aus Kunststoff geschaffen werden. Vorteilhafterweise kann der Kühlkörper ein länglicher, insbesondere extrudierter, bevorzugt quaderförmiger, vorzugsweise einstückiger bzw. einstückig hergestellter Profilkörper mit mehreren, die Außenseiten bzw. Außenwandungen desselben bildenden Profilkörperwandungen sein. Er kann dabei beispielsweise ein sogenannter Pocketprofilkörper sein.

Was diese äußeren Kühlköperwandungen betrifft, so kann eine großflächige erste Wandung vorgesehen sein und eine von dieser beabstandete, zu der ersten großflächigen Wandung insbesondere parallel verlaufende großflächige zweite Wandung. Zudem können zwei voneinander beabstandete, die erste großflächige Wandung und die zweite großflächige Wandung jeweils miteinander verbindende Schmalseitenwandungen vorgesehen sein.

Eine, mehrere oder sämtliche dieser Kühlkörperaußenwandungen können eben (bzw. ungekrümmt), gebogen (bzw. gekrümmt) oder gewellt ausgebildet sein.

Die Verwendung von ein oder mehreren solcher gekrümmten oder gewellten Kühlkörperaußenwandungen kann dabei beispielsweise die Anlage an zu kühlende Gegenstände verbessern oder erst ermöglichen, die ebenfalls über gekrümmte Außenwandungen verfügen, wie beispielsweise die Anlage an sogenannte Batterie- bzw. Akku-Rundzellen.

Der Kühlkörper aus Metall, insbesondere eine, mehrere oder jede Kühlkörperaußenwandung desselben, kann des Weiteren ganz oder teilweise auf einer, mehreren oder sämtlichen Außenseiten beschichtet sein, insbesondere (ggf. jeweils) mit einer elektrisch isolierenden Isolierschicht. Dies, um beispielsweise Kurzschlüsse zu verhindern, wenn der Kühlkörper an einen zu kühlenden Gegenstand angelegt wird, der nicht elektrisch isoliert ist. Diese bzw. die jeweilige elektrisch isolierende Isolierschicht kann beispielsweise eine (geeignete) Lackschicht sein, eine Folienschicht, eine PowderCoating-Schicht oder dergleichen.

Was die Verbindungsflächen des Kühlkörpers betrifft, so können diese dabei (endständige) Bereiche der Außenseiten dieser Profikörperwandungen bilden bzw. in (endständigen) Bereichen dieser Außenseiten angeordnet sein.

Zweckmäßigerweise weist die Aufnahme des Anschlussteils im Übrigen Aufnahmewandungen auf, die den Aufnahmeraum begrenzen und an deren Innenseiten die Verbindungsflächen des Anschlussteils bzw. der Aufnahme angeordnet sind bzw. deren Innenseiten die Verbindungsflächen der Aufnahme bilden.

In weiterer Ausbildung des Kühlbauteils kann das Anschlussteil eine Zulaufkammer mit Zulauföffnung zur Zuführung von Kühlmedium zu dem Kühlbauteil aufweisen.

Vorzugsweise kann weiter vorgesehen sein, dass in der Zulaufkammer Öffnungen oder offene Enden bzw. offene Seiten (insbesondere offene Querseiten) der Mediumkanäle einer ersten Gruppe von Mediumkanälen münden oder angeordnet sind, über die dieser ersten Gruppe von Mediumkanälen Kühlmedium, das dem Kühlbauteil über die Zulauföffnung und die Zulaufkammer zuführbar ist, zugeleitet werden kann.

In weiterer Ausbildung des Kühlbauteils kann das Anschlussteil des Weiteren eine insbesondere von der Zulaufkammer getrennte Ablaufkammer mit Ablauföffnung zur Abführung von Kühlmedium aus dem Kühlbauteil aufweisen.

Dabei kann vorgesehen sein, dass in der Ablaufkammer Öffnungen oder offene Enden bzw. Seiten einer (anderen) zweiten Gruppe von Mediumkanälen münden oder angeordnet sind, über die Kühlmedium aus den Mediumkanälen dieser, insbesondere von der ersten Gruppe getrennten zweiten Gruppe von Mediumkanälen in die Ablaufkammer fließen kann, das von dort über die Ablauföffnung aus dem Kühlbauteil abführbar ist.

Weiter kann vorgesehen sein, dass der erste Verbindungsbereich an dem einen Ende des Kühlkörpers angeordnet ist, und dass an einem oder dem zweiten, anderen Ende des Kühlkörpers ein zweiter Verbindungsbereich des Kühlkörpers mit mehreren Verbindungsflächen angeordnet ist mit jeweils insbesondere durch physikalische und/oder chemische Nano- oder Mikrostrukturierungsverfahren eingebrachten, dreidimensionalen Nano- und/oder Mikrostrukturen, der in den Aufnahmeraum einer Aufnahme einer Umlenkkappe eingebracht ist oder in den Aufnahmeraum einer Aufnahme eines weiteren Anschlussteils aus Kunststoff, über das dem Kühlkörper das Kühlmedium zuführbar ist und/oder über das von dem Kühlkörper das Kühlmedium abführbar ist, und dort mit der Aufnahme der Umlenkkappe bzw. der Aufnahme des weiteren Anschlussteils fluiddicht verbunden ist, indem jede Verbindungsfläche des Kühlkörpers jeweils einer zugeordneten Verbindungsfläche der Aufnahme gegenüberliegt und mit dieser (unter thermischer Direktfügung) verpresst ist.

Das weitere Anschlussteil kann dabei funktional genauso oder ähnlich ausgebildet sein wie das zuvor beschriebene (erste) Anschlussteil. So ist vorstellbar, dass beispielsweise an einem Ende des Kühlkörpers das (erste) Anschlussteil angeordnet ist und über dieses dem Kühlbauteil Kühlmedium zugeführt wird, und am anderen Ende das weitere bzw. zweite Anschlussteil, über das das Kühlmedium dann aus dem Kühlbauteil abgeführt wird. Hier sind diverse Ausführungsformen denkbar.

Weiter ist aber auch denkbar, dass das Kühlbauteil ein Anschlussteil aufweist, das über zwei oder mehr Aufnahmeräumen verfügt, wobei das Kühlbauteil dann entsprechend auch mehrere Kühlkörper (für jeden Aufnahmeraum einen) aufweist, wie sie in der vorliegenden Anmeldung beschrieben sind, und deren eines Ende dann jeweils den ersten Verbindungsbereich aufweist, der dann mit einem zugeordneten Aufnahmeraum in der in der Anmeldung beschriebenen Weise fluiddicht verbunden ist. Das jeweils andere, zweite Ende des jeweiligen Kühlkörpers kann dann jeweils den zweiten Verbindungsbereich aufweisen, der dann jeweils in der beschriebenen Weise mit einer solchen Umlenkkappe und/oder mit jeweils einem solchen weiteren Anschlussteil verbunden ist.

Dabei können die Mediumkanäle der ersten Gruppe und der zweiten Gruppe von Mediumkanälen auch im Bereich des anderen Endes des Kühlkörpers offene Seiten bzw. Enden oder Öffnungen aufweisen, wobei diese offenen Seiten/Enden bzw. Öffnungen in einem Umlenkraum der Umlenkkappe angeordnet sind bzw. in diesen münden. Dabei ist die Umlenckappe derart ausgebildet, dass Kühlmedium, das aus den in dort angeordneten offenen Seiten/Enden oder Öffnungen der Mediumkanäle der ersten Gruppe von Mediumkanälen in den Umlenkraum strömt oder strömen kann, in dem Umlenkraum zu den offenen Seiten/Enden oder Öffnungen der Mediumkanäle der zweiten Gruppe von Mediumkanälen umgelenkt wird und in diese eintreten kann, danach durch die Mediumkanäle der zweite Gruppe von Mediumkanälen fließt und weiter über die in der Ablaufkammer angeordneten offenen Seiten/Enden bzw. Öffnungen dieser Mediumkanäle in die Ablaufkammer strömt.

Die bzw. sämtliche Mediumkanäle können im Übrigen länglich und geradlinig ausgebildet sein und in dem Kühlkörper nebeneinander angeordnet parallel zur Haupterstreckungsrichtung des Kühlkörpers verlaufen.

Vorzugsweise kann jeder (längliche) Mediumkanal an zwei (gegenüberliegenden) Querseiten oder Enden offen sein.

Jeder (längliche) Mediumkanal kann des Weiteren an (allen) seinen Längsseiten (bezogen auf die Haupterstreckungsrichtung des Mediumkanals) durch Mediumkanalwandungen begrenzt sein. Dies insbesondere durch ein oder zwei Paare von sich jeweils mit Abstand gegenüberliegenden Mediumkanalwandungen, wobei die Mediumkanalwandungen eines der Paare oder des Paares jeweils durch die erste bzw. die zweite großflächige Wandung des Kühlbauteils gebildet wird.

Zusätzlich oder alternativ kann jeder (längliche) Mediumkanal des Weiteren an seinen Querseiten (bezogen auf die Haupterstreckungsrichtung des Mediumkanals) offen sein, wobei vorzugsweise die offenen Querseiten diejenigen offenen Seiten bilden, die in der Ablaufkammer bzw. der Zulaufkammer bzw. dem Umlenkraum angeordnet sind.

Weiter vorzugsweise verlaufen die Mediumkanalwandungen eines der Paare oder des Paares, insbesondere des anderen Paares, parallel zueinander und/oder senkrecht zu der ersten bzw. zweiten großflächigen Wandung.

Weiter vorzugsweise teilen sich jeweils benachbarte Mediumkanäle (seitlich) an einer Längsseite eine gemeinsame Mediumkanalwandung des Kühlkörpers.

Bei den beiden äußeren Mediumkanälen der (in einer Reihe) nebeneinander angeordneten Mediumkanälen kann im Übrigen eine der Mediumkanalwandungen durch eine der Schmalseitenwände des Kühlkörpers gebildet sein.

Weiter vorzugsweise verlaufen die Mediumkanäle jeweils insbesondere geradlinig zwischen dem mit dem einen endständigen Verbindungsbereich verbundenen Anschlussteil einerseits und der mit dem anderen endständigen Verbindungsbereich verbundenen Umlenkkappe andererseits.

Mit der oben beschrieben Ausgestaltung kann beispielsweise Kühlmedium über das Anschlussteil, insbesondere über die Zulauföffnung bzw. die Zulaufkammer, den Mediumkanälen der ersten Gruppe von Mediumkanälen über deren in der Zulaufkammer angeordneten offenen Seiten/Enden bzw. Öffnungen zugeleitet werden, das dann diese Mediumkanäle durchströmt, aus den anderen offenen Seiten/Enden bzw. Öffnungen dieser ersten Gruppe am anderen Ende des Kühlkörpers, die in dem Umlenkraum angeordnet sind, herausfließt und in die Umlenkkappe strömt, dann über die dort angeordneten offenen Seiten/Enden bzw. Öffnungen der zweiten Gruppe von Mediumkanälen in die Mediumkanäle dieser zweiten Gruppe umgelenkt wird, dann in diesen zum Anschlussteil (zurück)fließt, dann aus deren in der Ablaufkammer angeordneten offenen Seiten/Enden bzw. Öffnungen in die Ablaufkammer hineinströmt und schließlich aus dem Anschlussteil abgeführt wird. Auf dem beschriebenen Weg innerhalb des Kühlkörpers kann das Kühlmedium dabei die Abwärme eines/des zu kühlenden Gegenstands (über seine Außenwandungen bzw. Außenseiten) aufnehmen und diese ableiten.

Die Hauptströmungsrichtung des Kühlmediums kann im Übrigen innerhalb der Zulaufkammer winklig, vorzugsweise quer zu den Mediumkanälen bzw. zu der Haupterstreckungsrichtung der Mediumkanäle oder zu der Hauptströmungsrichtung in den Mediumkanälen verlaufen. In die Zulaufkammer kann dann dabei, insbesondere zur Optimierung der Strömung des Kühlmittels von der Zulauföffnung zu den Mediumkanälen, eine bevorzugt einstückig mit dem Anschlussteil, insbesondere der Aufnahme des Anschlussteils verbundene, mindestens bereichsweise winklig zur Hauptströmungsrichtung in der Zulaufkammer verlaufende (und insbesondere mindestens bereichsweise in Richtung der Zulauföffnung gekrümmte) Fluidleitwandung hineinragen, die das an ihr entlang strömende bzw. auf sie treffende Kühlmedium geeignet in Richtung der Mediumkanäle leitet/führt.

Alternativ oder zusätzlich kann die Hauptströmungsrichtung des Kühlmediums innerhalb der Ablaufkammer (ggf. jeweils) winklig, vorzugsweise quer zu den Mediumkanälen bzw. zu der Haupterstreckungsrichtung derselben oder zu der Hauptströmungsrichtung innerhalb derselben verlaufen, wobei (ggf. auch) in die Ablaufkammer eine insbesondere einstückig mit dem Anschlussteil, insbesondere der Aufnahme des Anschlussteils verbundene, mindestens bereichsweise winklig zur Hauptströmungsrichtung in der Ablaufkammer verlaufende (und insbesondere mindestens bereichsweise in Richtung der Ablauföffnung gekrümmte) Fluidleitwandung hineinragt. Dies ebenfalls insbesondere zur Optimierung der Strömung des Kühlmittels, allerdings aus den Mediumkanälen heraus hin zu der Ablauföffnung.

Bevorzugt kann sich die Zulauföffnung an einem Ende der Zulaufkammer befinden und an einem anderen Ende eine Anschlussöffnung, an die ein Anschlussteil eines identischen oder gleichartigen weiteren Kühlbauteils anschließbar ist, insbesondere zur Verbindung der Zulauföffnung des weiteren Kühlbauteils mit der Anschlussöffnung.

Zusätzlich oder alternativ kann vorgesehen sein, dass sich die Ablauföffnung an einem Ende der Ablaufkammer befindet und an einem anderen Ende eine Anschlussöffnung, an die ein Anschlussteil eines identischen oder gleichartigen weiteren Kühlbauteils anschließbar ist, insbesondere zur Verbindung der Ablauföffnung des weiteren Kühlbauteils mit der Anschlussöffnung.

Die Zulauföffnung und/oder die Anschlussöffnung können sich im Übrigen in einer Ebene erstrecken, die sich winklig, vorzugsweise quer zur Hauptströmungsrichtung innerhalb der Zulaufkammer bzw. zur Haupterstreckungsrichtung der Zulaufkammer erstreckt. Zusätzlich und/oder alternativ können sich die Ablauföffnung und/oder die Anschlussöffnung in einer Ebene erstrecken, die sich winklig, vorzugsweise quer zur Hauptströmungsrichtung innerhalb der Ablaufkammer bzw. zur Haupterstreckungsrichtung der Ablaufkammer erstreckt.

In weiterer Ausbildung des Kühlbauteils kann vorgesehen sein, dass das Kühlbauteil Verbindungsmittel, insbesondere Rastmittel aufweist zur lösbaren Verbindung des Kühlbauteils mit einem identischen weiteren Kühlbauteil.

Dies insbesondere derart, dass nach einer solchen Verbindung die Anschlussöffnung der Zulaufkammer des Kühlbauteils mit der Zulauföffnung der Zulaufkammer des weiteren Kühlbauteils unter fluidleitender Verbindung zwischen diesen Öffnungen fluchtet und/oder derart, dass nach einer solchen Verbindung die Anschlussöffnung der Ablaufkammer des Kühlbauteils mit der Ablauföffnung der Ablaufkammer des weiteren Kühlbauteils unter fluidleitender Verbindung zwischen diesen Öffnungen fluchtet.

Was das erfindungsgemäße Herstellverfahren betrifft, so kann des Weiteren vorgesehen sein, dass alle Verbindungsflächen des Kühlkörpers oder nur ein Paar von bzw. der sich insbesondere mit Abstand zueinander gegenüberliegenden Verbindungsflächen des Kühlkörpers mit der jeweils gegenüberliegenden Verbindungsfläche des Anschlussteils verpresst werden/wird, indem ein Pressorgan jeweils die jeweilige Verbindungsfläche des Anschlussteils gegen die ihr jeweils gegenüberliegende Verbindungsfläche des Kühlkörpers drückt.

Weiter kann allgemein vorgesehen sein, dass alle Verbindungsflächen des Kühlkörpers oder nur ein Paar von sich insbesondere gegenüberliegenden Verbindungsflächen des Kühlkörpers mit der jeweils gegenüberliegenden Verbindungsfläche des Anschlussteils verpresst werden/wird, indem der Abstand gegenüberliegender Verbindungsflächen des Kühlkörpers zueinander auf den Abstand gegenüberliegender Verbindungsflächen des Anschlussteils zueinander abgestimmt ist oder wird, sodass durch das Erwärmen dieser Verbindungsflächen des Kühlkörpers in dem in den Aufnahmeraum des Anschlussteils eingeführten Zustand des Verbindungsbereichs des Kühlkörpers aufgrund thermischer Ausdehnung des Kühlkörpermaterials eine Presspassung entsteht, in deren Zuge die jeweilige Verbindungsfläche des Kühlkörpers gegen die jeweils gegenüberliegende Verbindungsfläche des Anschlussteils gedrückt wird.

Weiter kann vorgesehen sein, dass durch ein jeweiliges Pressorgan diejenigen Verbindungsflächen des Anschlussteils gegen die jeweils gegenüberliegende Verbindungsfläche des Kühlkörpers gedrückt werden, die jeweils der ersten großflächigen Wandung bzw. der zweiten großflächigen Wandung des Kühlkörpers gegenüberliegen, und/oder dass diejenigen Verbindungsflächen des Anschlussteils, die jeweils einer Verbindungsfläche einer der Schmalseitenwände des Kühlkörpers gegenüberliegen, durch die Presspassung mit der jeweiligen Verbindungsfläche des Kühlkörpers verbunden werden.

Weiter kann vorgesehen sein, dass die Verbindungsflächen sämtlicher dieser Wandungen des Kühlkörpers mit der jeweils gegenüberliegenden Verbindungsfläche des Anschlussteils durch ein jeweiliges, die Verbindungfläche des Anschlussteils gegen die jeweilige Wandung drückendes Pressorgan verbunden werden.

Weiter kann vorgesehen sein, dass das Drücken der jeweiligen Verbindungsfläche des Anschlussteils gegen die jeweils gegenüberliegende Verbindungsfläche des Kühlkörpers mittels des jeweiligen Pressorgans erfolgt, indem dieses Druck auf diejenige Wandung der Aufnahme ausübt, an der die jeweilige Verbindungsfläche angeordnet ist, insbesondere auf die Außenseite dieser Wandung.

Weitere Merkmale der vorliegenden Erfindung ergeben sich aus den beigefügten Patentansprüchen, der nachfolgenden Beschreibung bevorzugter Ausführungsbeispiele sowie aus den beigefügten Zeichnungen.

Darin zeigt:

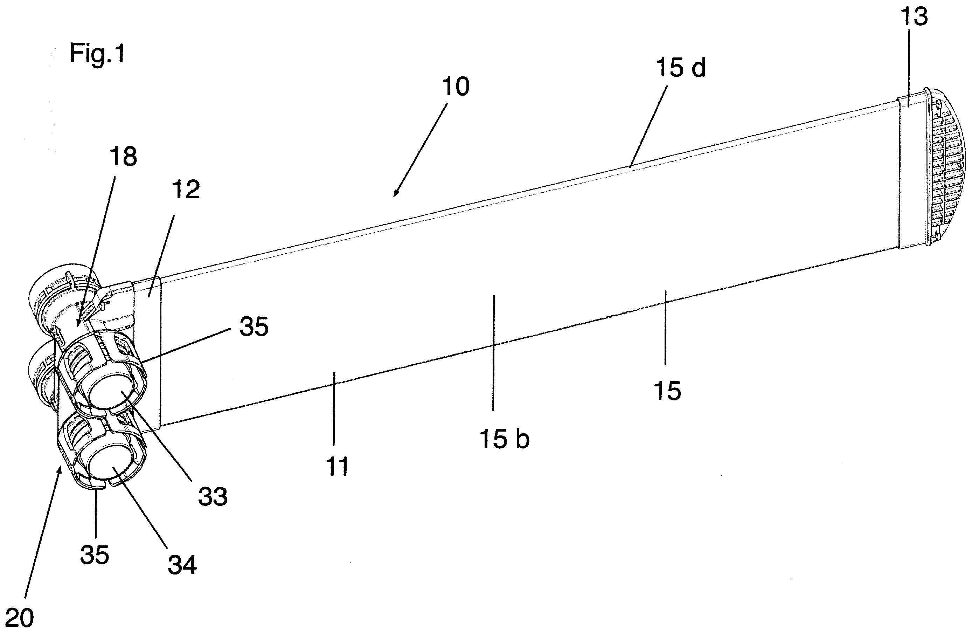

- Fig. 1: eine Ausführungsform eines Kühlbauteils mit Kühlkörper, Anschlussteil (an einem Ende des Kühlkörpers) und Umlenkkappe (am anderen Ende des Kühlkörpers), in Schrägansicht von unten,

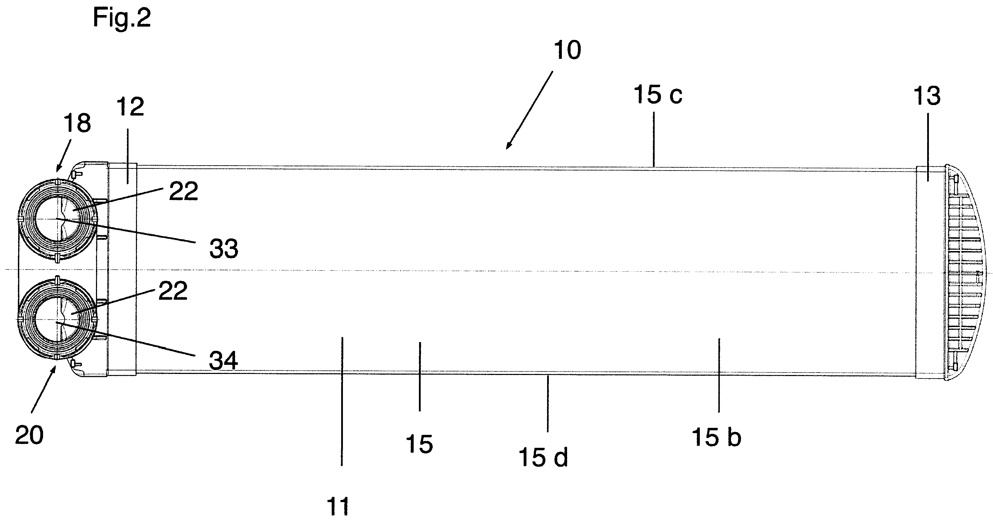

- Fig. 2: eine Unteransicht des Kühlbauteils aus Fig. 1,

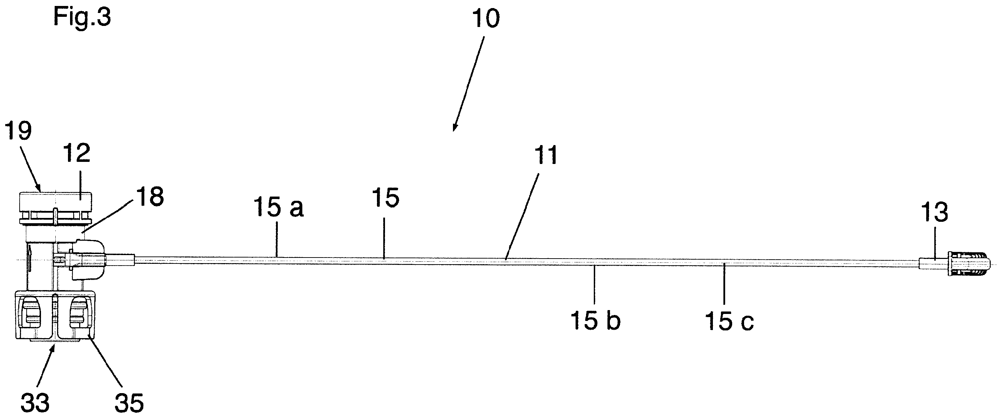

- Fig. 3: eine Seitenansicht des Kühlbauteils aus Fig. 1,

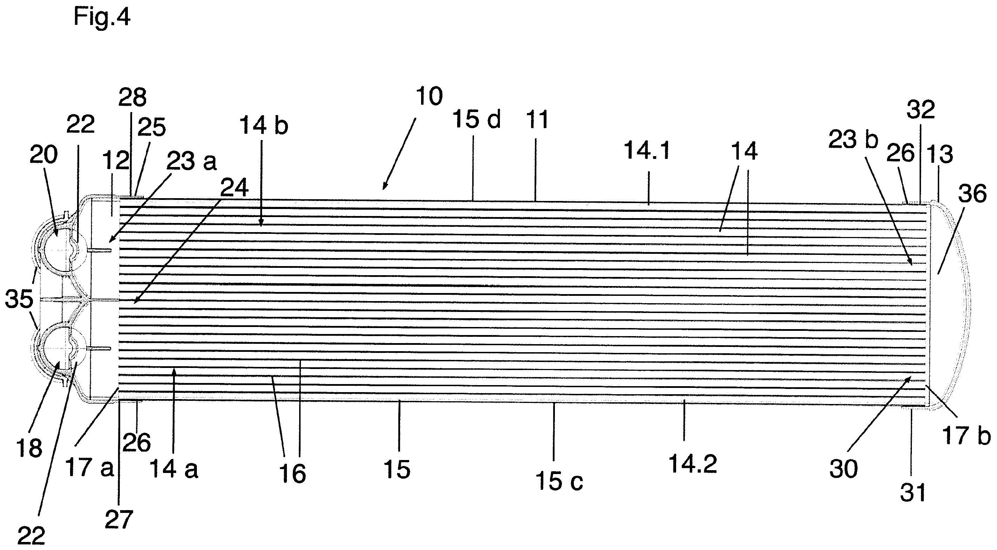

- Fig. 4: einen Längsschnitt (horizontal) durch das Kühlbauteil aus Fig. 1,
- Fig. 5: einen Schnitt durch das Anschlussteil des Kühlbauteils aus Fig. 1,

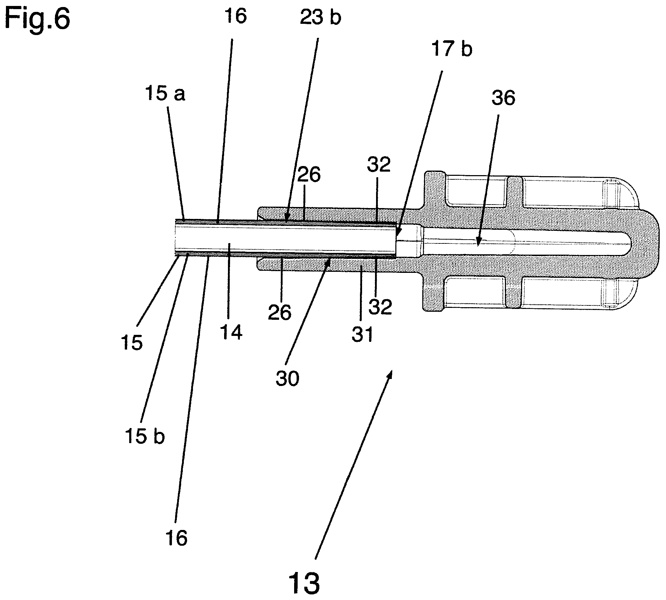

- Fig. 6: einen Schnitt durch die Umlenkkappe aus Fig. 1.

In den Zeichnungen ist ein Kühlbauteil 10 gezeigt, wie es beispielsweise im Rahmen der Kühlung von Batterie- bzw. von Akkumulatorensystemen von Elektrofahrzeugen verwendet wird, um die jeweiligen Batterien bzw. die einzelnen Zellen zu kühlen.

Ein solches Kühlbauteil 10 ist dabei in der Regel Bestandteil einer übergeordneten Kühleinrichtung, die dafür sorgt, dass kontinuierlich Kühlmedium durch das Kühlbauteil 10 geführt wird, das dabei Abwärme des zu kühlenden Gegenstands aufnimmt und diese dann abführt. Die hierfür notwendigen Bauteile der Kühleinrichtung, etwa eine geeignete Pumpe, Zu- und Ablaufleitungen für das Kühlmedium etc., sind im Stand der Technik bekannt und werden daher nicht näher erläutert.

Im vorliegenden Fall kann das Kühlbauteil 10 im Einsatz mit (nicht gezeigten) identischen weiteren Kühlbauteilen der Kühleinrichtung verbunden werden, die dann zur gleichen Zeit mehrere zu kühlende Gegenstände kühlen können, beispielsweise mehrere Batterien bzw. Batteriezellen.

Das Kühlbauteil 10 verfügt über einen Kühlkörper 11 aus Metall, vorliegend aus Aluminium, der im Einsatz an dem zu kühlenden Gegenstand anliegt oder zumindest unmittelbar benachbart zu diesem angeordnet wird.

Der Kühlkörper 11 ist länglich ausgebildet, vorliegend im Wesentlichen als (sehr) flacher Quader.

Bezogen auf die Haupterstreckungsrichtung des Kühlbauteils 10 bzw. des Kühlkörpers 11 ist an einem Ende desselben ein Anschlussteil 12 angeordnet, über das dem Kühlbauteil 10 Kühlmedium, wie etwa Kühlwasser oder dergleichen, zugeführt werden kann, das innerhalb einer ersten Gruppe 14 a von länglichen Mediumkanälen 14 dann in der Haupterstreckungsrichtung des Kühlkörpers 11 bzw. in Längsrichtung zu dem anderen Ende des Kühlkörpers 11 geführt wird, dann in einer an dem anderen Ende des Kühlbauteils 10 bzw. des Kühlkörpers 11 angeordneten Umlenkkappe 13 umgelenkt wird und in entgegengesetzter Richtung durch eine zweite Gruppe 14 b von länglichen Mediumkanäle in entgegengesetzter Richtung durch den Kühlkörper 10 strömt, bis es wieder das Anschlussteil 12 erreicht und über das Anschlussteil 12 aus dem Kühlbauteil 10 herausgeführt oder abgeführt wird.

Auf seinem Weg durch den Kühlkörper 11 bzw. die Mediumkanäle 14 nimmt das Kühlmedium im Betrieb der Kühleinrichtung bzw. des Kühlbauteils 10 die Abwärme des zu kühlenden Gegenstands unter Kühlung des zu kühlenden Gegenstandes auf und transportiert diese ab.

Der Kühlkörper 11 ist vorliegend einstückig gefertigt. Dabei kann es sich um einen Profilkörper bzw. ein Profilstück (Pocketprofil) handeln, das im (Aluminium-) Extrusionsverfahren hergestellt wurde.

Der Kühlkörper 11 verfügt vorliegend über vier Kühlkörperaußenwandungen 15, nämlich eine erste großflächige, obere Wandung 15 a, eine zweite großflächige, der oberen Wandung parallel mit Abstand gegenüberliegende, untere Wandung 15 b, sowie zwei parallel zueinander verlaufende, die obere Wandung 15 a und die untere Wandung 15 b jeweils miteinander verbindende Schmalseitenwandungen 15 c bzw. 15 d.

Die (länglichen) Mediumkanäle 14 sind im Inneren des Kühlkörpers 11 angeordnet, also im Inneren des durch die Körperaußenwandungen 15 eingeschlossenen Raums. Die Mediumkanäle 14 erstrecken sich dabei parallel zur Haupterstreckungsrichtung des Kühlkörpers 11 bzw. parallel zu den Schmalseitenwandungen 15 c bzw. 15 d. Bezogen auf einen Querschnitt durch Kühlkörper 11 sind die einzelnen Mediumkanäle 14 in einer Reihe nebeneinander angeordnet.

Jeder (längliche) Mediumkanal 14 ist des Weiteren an (allen) seinen Längsseiten (bezogen auf die Haupterstreckungsrichtung des jeweiligen Mediumkanals 14) durch Mediumkanalwandungen 16 begrenzt. Dies vorliegend jeweils konkret durch zwei Paare von sich jeweils mit Abstand gegenüberliegenden Mediumkanalwandungen 16.

Dabei wird jeder Mediumkanal 14 an zwei gegenüberliegenden (vertikalen bzw. senkrecht zu der oberen und unteren großflächigen Wandung 15 a bzw. 15 b verlaufenden) Längsseiten, nämlich in Querrichtung bzw. senkrecht zur Haupterstreckungsrichtung des Kühlkörpers 11, begrenzt durch ein erstes Paar von jeweils zwei mit Abstand zueinander angeordneten, jeweils zueinander parallel in der Haupterstreckungsrichtung des Kühlkörpers verlaufenden Mediumkanalwandungen 16.

Bei den beiden äußeren Mediumkanälen 14.1 bzw. 14.2 wird dabei eine dieser Mediumkanalwandungen 16 dieses ersten Paares jeweils durch die jeweilige Körperaußenwandung 15 des Kühlkörpers 11 gebildet, vorliegend die Schmalseitenwandung 15 c bzw. die Schmalseitenwandung 15 d.

Jeder (längliche) Mediumkanal 14 ist des Weiteren an seinen anderen beiden Längsseiten durch jeweils ein anderes Paar von Mediumkanalwandungen 16 begrenzt, bei dem die eine Mediumkanalwandung 16 des Paares durch die obere großflächige Wandung 15 a gebildet wird, die andere Mediumkanalwandung 16 des Paares durch die untere großflächige Wandung 15 b.

Jeder Mediumkanal 14 ist vorliegend des Weiteren an seinen beiden Enden bzw. Querseiten offen, nämlich an den Querseiten 17 a und 17 b. Mit anderen Worten findet sich dort keine Wandung, sodass durch die Querseiten 17 a und 17 b Kühlmedium in den Mediumkanal 14 hinein- bzw. aus diesem herausfließen kann.

Was das Anschlussteil 12 betrifft, so weist dieses eine Zulaufkammer 18 mit (oberer) Zulauföffnung 19 auf, über die den Mediumkanälen 14 der ersten Gruppe 14 a von Mediumkanälen 14 Kühlmedium zuführbar ist. Zu diesem Zweck sind die offenen Querseiten 17 a der Mediumkanäle 14 der ersten Gruppe 14 a von Mediumkanälen 14 innerhalb der Zulaufkammer 18 angeordnet, sodass das Kühlmedium unmittelbar aus der Zulaufkammer 18 in/über die offenen Querseiten 17 a in die Mediumkanäle 14 dieser ersten Gruppe 14 a fließen kann.

Das Anschlussteil 12 verfügt des Weiteren über eine von der Zulaufkammer 18 getrennte Ablaufkammer 20 mit Ablauföffnung 21, über die aus den Mediumkanälen 14 der zweiten Gruppe 14 b von Mediumkanälen 14 Kühlmedium abführbar ist. Zu diesem Zweck sind die offenen Querseiten 17 a der Mediumkanäle 14 der zweiten Gruppe 14 b von Mediumkanälen innerhalb der Ablaufkammer 20 angeordnet, sodass das Kühlmedium unmittelbar aus der Ablaufkammer 18 in/über die offenen Querseiten 17 a in die Mediumkanäle 14 dieser zweiten Gruppe 14 b fließen kann.

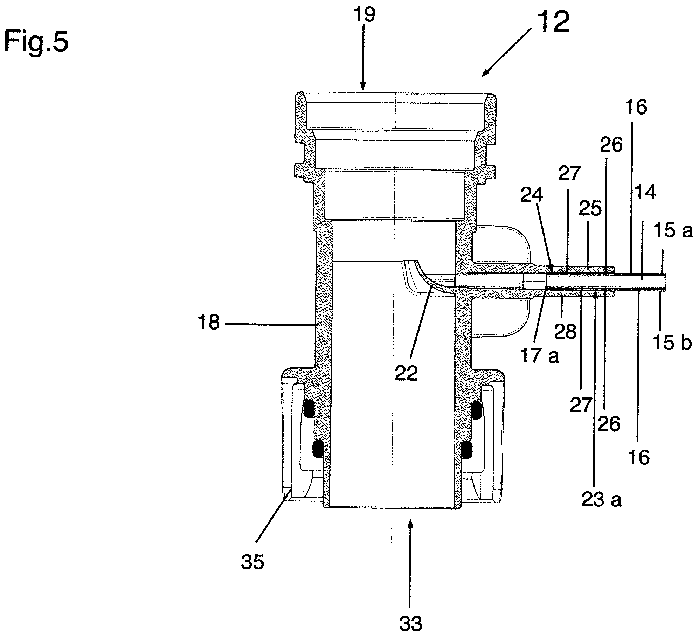

Wie beispielsweise in Fig. 5 zu erkennen ist, verläuft im vorliegenden Fall die Haupterstreckungsrichtung der Mediumkanäle 14 jeweils senkrecht zu der Haupterstreckungsrichtung bzw. Hauptströmungsrichtung der Zulaufkammer 18 bzw. auch der Ablaufkammer 20.

Um dennoch zu ermöglichen, dass Kühlmedium, das über die Zulauföffnung 19 der Zulaufkammer 18 zugeführt wird, in effizienter Weise in die Mediumkanäle 14, nämlich die erste Gruppe 14 a der Mediumkanäle 14 geleitet wird, ist in der Zulaufkammer 18 eine vorliegend einstückig mit dem Anschlussteil 12 verbundene, mindestens bereichsweise winklig zur Hauptströmungsrichtung bzw. Haupterstreckungsrichtung der Zulaufkammer 18 verlaufende (und insbesondere mindestens bereichsweise in Richtung der Zulauföffnung 19 gekrümmte) Fluidleitwandung 22 angeordnet.

Diese ragt vorliegend ausgehend von ihrem Ende, mit dem sie einstückig mit dem Anschlussteil 12 verbunden ist, unter einer Krümmung in Richtung der Zulauföffnung 19 in die Zulaufkammer 18 hinein, und sorgt dafür, dass Kühlmedium, das (in Fig. 5 von oben) auf sie trifft, zu den Mediumkanälen 14 der ersten Gruppe 14 a gelenkt wird.

In ganz analoger Weise (nicht gezeigt) findet sich auch in der Ablaufkammer 20 eine entsprechende Fluidleitwandung, die dort dafür sorgt, dass Kühlmedium, das aus den Mediumkanälen 14 der zweiten Gruppe 14 b in die Ablaufkammer 20 strömt, in Richtung der Ablauföffnung 21 gelenkt wird.

Die Zulauföffnung 19 befindet sich vorliegend im Übrigen an einem Ende der Zulaufkammer 18, und an einem anderen Ende befindet sich eine Anschlussöffnung 33, an die ein Anschlussteil eines (nicht gezeigten) identischen weiteren Kühlbauteils anschließbar ist, insbesondere zur Verbindung der Zulauföffnung des weiteren Kühlbauteils mit der Anschlussöffnung 33.

Die Ablauföffnung 21 befindet sich in analoger Weise an einem Ende der Ablaufkammer 20 und an einem anderen Ende einer Anschlussöffnung 34 der Ablaufkammer 20, an die ein Anschlussteil eines identischen weiteren Kühlbauteils anschließbar ist, insbesondere zur Verbindung der Ablauföffnung 21 des weiteren Kühlbauteils mit der Anschlussöffnung 34.

Das Kühlbauteil 10 bzw. vorliegend das Anschlussteil 12 verfügt des Weiteren noch über Verbindungsmittel 35, insbesondere Rastmittel, zur lösbaren Verbindung des Kühlbauteils mit einem identischen weiteren Kühlbauteil. Dies insbesondere derart, dass nach der Verbindung die Anschlussöffnung 33 der Zulaufkammer 18 mit der Zulauföffnung der Zulaufkammer des weiteren Kühlbauteils unter fluidleitender Verbindung zwischen diesen Öffnungen fluchtet bzw. dass nach der Verbindung die Anschlussöffnung 34 der Ablaufkammer 20 mit der Ablauföffnung der Ablaufkammer des weiteren Kühlbauteils unter fluidleitender Verbindung zwischen diesen Öffnungen fluchtet.

Besonders wichtig ist nun, dass - anders als der Kühlkörper 11 - sowohl das Anschlussteil 12 als auch die Umlenkkappe 13 nicht aus Metall (bzw. ggf. aus einer Metalllegierung) bestehen, sondern aus Kunststoff. Diese Bauteile sind dabei vorliegend jeweils einstückig ausgebildet und als Kunststoff-Spritzgussteil hergestellt, etwa aus Thermoplast.

In besonderer Weise sind der Kühlkörper 11 einerseits und das Anschlussteil 12 bzw. die Umlenkkappe 13 jeweils andererseits miteinander fest und fluiddicht verbunden.

So ist zur Verbindung des Anschlussteils 12 mit dem Kühlkörper 11 ein erster, endständiger Verbindungsbereich 23 a des Kühlkörpers 11 in einen (vorliegend zum dem ersten, im Wesentlichen quaderförmigen Verbindungsbereich 23 a des Kühlkörpers 11 passenden, im Wesentlichen quaderförmigen) Aufnahmeraum 24 einer (hohlquaderförmigen) Aufnahme 25 des Anschlussteils 12 eingebracht und dort mit der Innenseite der Aufnahme 25 fluiddicht verbunden, und zwar mit an der Innenseite angeordneten Verbindungsflächen 27 der Aufnahme 25.

Der metallische Kühlkörpers 11 weist (ebenfalls) Verbindungsflächen auf, nämlich Verbindungsflächen 26 in dem ersten Verbindungsbereich 23 a. Jede dieser (metallischen) Verbindungsflächen 26 des Kühlkörpers 11 weisen dabei jeweils durch physikalische und/oder chemische Nano- oder Mikrostrukturierungsverfahren (wie etwa chemischem Ätzen oder Laserstrahlstrukturieren) in die jeweilige Oberfläche eingebrachte, dreidimensionale Nano- und/oder Mikrostrukturen auf.

Die Verbindungsflächen 26 des Kühlkörpers 11 sind im vorliegenden Fall konkret an den Außenseiten der Körperaußenwandungen 15 angeordnet, und zwar, wie bereits erwähnt, jeweils im ersten Verbindungsbereich 23 a, also in demjenigen Endbereich bzw. Endabschnitt des Kühlkörpers 11, der in den Aufnahmeraum 24 der Aufnahme 25 eingebracht ist und der unmittelbar an die Aufnahme 25 bildende Wandungen 28 angrenzt/anliegt bzw. an die Wandungen 28, die den Aufnahmeraum 24 bilden bzw. begrenzen.

Jede der in der beschriebenen Weise strukturierten Verbindungsflächen 26 des Kühlkörpers 11 liegt dabei jeweils einer zugeordneten Verbindungsfläche 27 der Aufnahme 25 gegenüber ist und mit dieser verbunden, und zwar (unter thermischer Direktfügung) verpresst, wie nachfolgend noch näher ausgeführt werden wird.

In ähnlicher Weise ist im Übrigen auch die Umlenkkappe 13 mit dem Kühlkörper 11 verbunden. Zu diesem Zweck weist der Kühlkörper 11 an seinem anderen Ende, an dem die Umlenkkappe 13 sitzt, einen zweiten Verbindungsbereich 23 b auf, ebenfalls mit mehreren Verbindungsflächen 26 sowie mit jeweils insbesondere durch die genannten physikalischen und/oder chemischen Nano- oder Mikrostrukturierungsverfahren in die jeweilige Oberfläche eingebrachten, dreidimensionalen Nano- und/oder Mikrostrukturen.

Die Umlenkkappe 13 verfügt - ähnlich wie das Anschlussteil 12 - dabei ebenfalls über eine Aufnahme 31 mit einem Aufnahmeraum 30, in den der zweite Verbindungsbereich 23 b des Kühlkörpers 11 eingebracht ist, und ist dort - in analoger Weise wie vorstehend für die Verbindung von Kühlkörper 11 und Aufnahme 25 des Anschlussteils 12 beschrieben - mit der Aufnahme 31 der Umlenkkappe 13 fluiddicht verbunden, indem jede Verbindungsfläche 26 des Kühlkörpers 11 jeweils einer zugeordneten Verbindungsfläche der Aufnahme 31 gegenüberliegt und mit dieser in der beschriebenen Weise verpresst ist.

Die Mediumkanäle 14 verfügen, wie oben bereits angedeutet, im Übrigen auch im Bereich des anderen Endes des Kühlkörpers 11 über offene Querseiten 17 b, wobei diese offenen Querseiten 17 b in einem Umlenkraum 36 der Umlenkkappe 13 angeordnet sind. Die Umlenkkappe 13 ist dabei derart ausgebildet, dass Kühlmedium, das aus den in diesem Bereich des anderen Endes angeordneten offenen Querseiten 17 b der ersten Gruppe 14 a von Mediumkanälen 14 in den Umlenkraum 36 strömt, in dem Umlenkraum 36 zu den offenen Seiten 17 b der Mediumkanäle 14 der zweiten Gruppe 14 b von Mediumkanälen 14 umgelenkt wird, in diese eintritt und in umgekehrter Richtung dann - in der zweiten Gruppe 14 b von Mediumkanälen - durch den Kühlkörper 11 zu dem Anschlussteil 12 zurückströmt.

Die konkrete Herstellung des Kühlbauteils 10 und insbesondere die vorgenannte Verbindung des metallischen Kühlbauteils 10 mit dem aus Kunststoff bestehenden Anschlussteil 12 und mit der aus Kunststoff bestehenden Umlenkkappe 13 erfolgt dabei in besonderer Weise.

Zunächst werden der Kühlkörper 11, das Anschlussteil 12 und die Umlenkkappe 13 separat vorgefertigt.

Anschließend werden die vorgenannten Bauteile 11, 12, 13 miteinander verbunden. Dies wird nachfolgend exemplarisch an der Verbindung des Anschlussteils 12 mit dem Kühlkörper 11 beschrieben. Die Verbindung des Kühlkörpers 11 mit der Umlenkkappe 13 erfolgt in analoger Weise.

Zur Verbindung von Kühlkörper 11 und Anschlussteil 12 werden diese beiden Bauteile zunächst relativ zueinander bewegt. Beispielsweise, indem das Anschlussteil 12 ortsfest festgehalten wird und der Kühlkörper 11 mittels eines geeigneten Förderorgans in Richtung des Anschlussteils 12 bewegt wird. Es versteht sich, dass der Vorgang auch umgekehrt ablaufen kann oder dass beide Bauteile aufeinander zu bewegt werden können.

Im Rahmen der vorgenannten Relativbewegung wird der Kühlkörper 11 dann derart relativ zu dem Anschlussteil 12 bewegt, dass dabei der erste Verbindungsbereich 23 a des Kühlkörpers passgenau so in der Aufnahme 25 bzw. dem Aufnahmeraum 24 platziert wird, dass jede der Verbindungsflächen 26 des ersten Verbindungsbereichs 23 a des Kühlkörpers 11 jeweils einer zugeordneten Verbindungsfläche 27 der Aufnahme 25 des Anschlussteils 12 gegenüberliegt.

Danach, währenddessen und/oder davor werden dann der metallische Kühlkörper 11, zumindest aber die Verbindungsflächen 26 des ersten Verbindungsbereichs 23 a des Kühlkörpers 11, insbesondere mittels einer im Stand der Technik bekannten Induktionsheizung (auch andere Erwärmungstechniken sind natürlich denkbar), auf eine Temperatur erhitzt oder erwärmt, die mindestens der Erweichungstemperatur oder der Schmelztemperatur des Kunststoffs des Anschlussteils 12 bzw. der Aufnahme 25 des Anschlussteils 12 entspricht.

Die Wärme des Kühlkörpers 11 überträgt sich dann, wenn sich der erste Verbindungsbereich 23 a des Kühlkörpers 11 an seiner gewollten Endposition in der Aufnahme 25 befindet, auf das Anschlussteil 12 bzw. dessen Verbindungsflächen 27, was dann zu einem Aufschmelzen der Verbindungsflächen 27 führt.

Beispielsweise durch ein bzw. ggf. jeweils ein Pressorgan, wie etwa eine Pressbacke (nicht gezeigt), das jeweils von außen auf die zu verbindenden Wandungen 28 der Aufnahme 25 drückt, wird dann während und/oder unmittelbar vor und/oder unmittelbar nach dem Aufschmelzen die jeweilige, an der Innenseite der jeweiligen Wandung 28 der Aufnahme 25 angeordnete Verbindungsfläche 27 der Aufnahme 25 gegen die jeweilige (strukturierte) Verbindungsfläche 26 des Kühlkörpers 11 gedrückt bzw. gepresst und so mit dieser fluiddicht verbunden (thermische Direktfügung).

Für eine oder mehrere der zu verbindenden Flächen kann im Übrigen auch vorgesehen sein, dass jeweils ein Paar von sich mit Abstand gegenüberliegenden Verbindungsflächen 26 des Kühlkörpers 11 durch eine alternative Presspassung mit den entsprechenden gegenüberliegenden Wandungen verbunden wird.

Beispielsweise könnten die Verbindungsflächen 26 der Schmalseitenwandungen 15 c, 15 d bzw. die an den Schmalseitenwandungen 15 c, 15 d angeordneten Verbindungsflächen 26 mit den ihnen jeweils gegenüberliegenden Verbindungsflächen 27 der Wandungen 28 der Aufnahme 25 des Anschlussteils 12 verpresst werden, indem im Vorfeld der Verbindung der Abstand der Verbindungsflächen 26 der Schmalseitenwandungen 15 c, 15 d zueinander auf den Abstand der gegenüberliegender Verbindungsflächen 27 des Anschlussteils 12 so abgestimmt ist oder wird, dass sich die Verbindungsflächen 26, wenn sich diese später bereits positionsgenau bzw. in ihrer jeweiligen Endposition in dem Aufnahmeraum 24 des Anschlussteils 12 befinden, durch das (erst in dieser Position erfolgende) Erwärmen der Verbindungsflächen 26 des Kühlkörpers 11 thermisch so ausdehnen, dass sie hierdurch (also ohne ein externes Pressorgan) gegen die jeweils gegenüberliegende Verbindungsfläche 27 der Aufnahme 25 bzw. der Wandung 28 der Aufnahme 25 gedrückt/gepresst werden und dabei die Verbindungsflächen 27 der Aufnahme 25 erwärmen bzw. anschmelzen, sodass (nach dem späteren Erkalten) eine entsprechende Presspassung entsteht.

Es kann beispielsweise auch vorgesehen sein, dass durch ein jeweiliges Pressorgan nur diejenigen Verbindungsflächen 27 der Aufnahme 25 mit den gegenüberliegende Verbindungsfläche 26 des Kühlkörpers 11 verpresst werden, die jeweils der ersten großflächigen Wandung 15 a bzw. der zweiten großflächigen Wandung 15 b des Kühlkörpers 11 gegenüberliegen, und dass die anderen Verbindungsflächen 27 der Aufnahme 25, die jeweils der Verbindungsfläche 26 der jeweiligen Schmalseitenwandung 15 c bzw. 15 d des Kühlkörpers 11 gegenüberliegen, durch die vorstehende Presspassung mit der jeweiligen Verbindungsfläche 26 des Kühlkörpers 11 verbunden werden.

### Bezugszeichenliste:

- 10: Kühlbauteil
- 11: Kühlkörper
- 12: Anschlussteil
- 13: Umlenkkappe
- 14: Mediumkanal
- 14.1: Äußerer Mediumkanal
- 14.2: Äußerer Mediumkanal
- 14 a: erste Gruppe von Mediumkanälen
- 14 b: zweite Gruppe von Mediumkanälen
- 15: Körperaußenwandungen
- 15 a: erste großflächige Wandung
- 15 b: zweite großflächige Wandung
- 15 c: Schmalseitenwandung
- 15 d: Schmalseitenwandung
- 16: Mediumkanalwandung
- 17 a: offene Querseite
- 17 b: offene Querseite
- 18: Zulaufkammer
- 19: Zulauföffnung
- 20: Ablaufkammer
- 21: Ablauföffnung
- 22: Fluidleitwandung
- 23 a: erster Verbindungsbereich Kühlkörper
- 23 b: zweiter Verbindungsbereich Kühlkörper
- 24: Aufnahmeraum Anschlussteil
- 25: Aufnahme Anschlussteil
- 26: Verbindungsflächen Kühlkörper
- 27: Verbindungsflächen Aufnahme Anschlussteil
- 28: Wandungen Aufnahme
- 30: Aufnahmeraum Umlenkkappe
- 31: Aufnahme Umlenkkappe
- 32: Verbindungsflächen Aufnahme Umlenkkappe
- 33: Anschlussöffnung Zulaufkammer
- 34: Anschlussöffnung Ablaufkammer
- 35: Verbindungsmittel
- 36: Umlenkraum Umlenkkappe

## Patentansprüche

1. Verfahren zur Herstellung eines Kühlbauteils, der über einen Kühlkörper (11) aus Metall oder aus einer Metalllegierung verfügt, insbesondere Aluminium, mit dem ein Gegenstand gekühlt werden kann, wobei der Kühlkörper (11) ein oder mehrere, vorzugsweise parallele Mediumkanäle zum Durchfluss von Kühlmedium aufweist, sowie ein mit dem Kühlkörper (11) fluiddicht verbundenes Anschlussteil (12), über das dem Kühlkörper (11) das Kühlmedium zuführbar ist und/oder über das von dem Kühlkörper (11) das Kühlmedium abführbar ist, mit folgenden Maßnahmen:
a) Einführen eines insbesondere endständigen Verbindungsbereichs eines/des vorgefertigten, insbesondere durch Profilextrusion hergestellten, insbesondere einstückig gefertigten Kühlkörpers (11) in den Aufnahmeraum einer Aufnahme eines/des vorgefertigten, insbesondere spritzgegossenen Anschlussteils (12) aus Kunststoff für den Kühlkörper (11) mittels Relativbewegung zwischen Kühlkörper (11) und Anschlussteil (12), sodass jede von mehreren, sich jeweils insbesondere parallel gegenüberliegenden Verbindungsflächen des Verbindungsbereichs des Kühlkörpers (11) mit jeweils insbesondere durch physikalische und/oder chemische Nano- oder Mikrostrukturierungsverfahren eingebrachten, dreidimensionalen Nano- und/oder Mikrostrukturen, jeweils einer zugeordneten Verbindungsfläche der Aufnahme des Anschlussteils (12) gegenüberliegt, insbesondere einer jeweils zugeordneten Verbindungsfläche, die an einer Innenseite einer Wandung der Aufnahme angeordnet ist,
b) Erwärmen der Verbindungsflächen des Kühlkörpers (11), insbesondere mittels Induktion, auf eine Temperatur, die mindestens der Erweichungstemperatur oder der Schmelztemperatur des Kunststoffs des Anschlussteils (12) entspricht, insbesondere bevor der Verbindungsbereich des Kühlkörpers (11) in den Aufnahmeraum der Aufnahme eingeführt wird und/oder während sich der Verbindungsbereich in dem Aufnahmeraum befindet,
c) fluiddichtes Verbinden von allen erwärmten Verbindungsflächen des Kühlkörpers (11) mit der jeweils gegenüberliegenden Verbindungsfläche des Anschlussteils (12) durch Verpressen dieser sich gegenüberliegenden Verbindungsflächen unter Aufschmelzen der Verbindungsfläche des Anschlussteils (12) durch die Wärme der Verbindungsfläche des Kühlkörpers (11).

2. Verfahren gemäß Anspruch 1, **dadurch gekennzeichnet, dass** alle Verbindungsflächen des Kühlkörpers (11) oder nur ein Paar von insbesondere mit Abstand zueinander sich gegenüberliegenden Verbindungsflächen des Kühlkörpers (11) mit der jeweils gegenüberliegenden Verbindungsfläche des Anschlussteils (12) verpresst werden/wird, indem jeweils ein Pressorgan die jeweilige Verbindungsfläche des Anschlussteils (12) gegen die ihr jeweils gegenüberliegende Verbindungsfläche des Kühlkörpers (11) drückt, und/oder dass alle Verbindungsflächen des Kühlkörpers (11) oder nur ein Paar von sich insbesondere gegenüberliegenden Verbindungsflächen des Kühlkörpers (11) mit der jeweils gegenüberliegenden Verbindungsfläche des Anschlussteils (12) verpresst werden/wird, indem der Abstand gegenüberliegender Verbindungsflächen des Kühlkörpers (11) zueinander auf den Abstand gegenüberliegender Verbindungsflächen des Anschlussteils (12) zueinander abgestimmt ist oder wird, sodass durch das Erwärmen dieser Verbindungsflächen des Kühlkörpers (11) in dem in den Aufnahmeraum des Anschlussteils (12) eingeführten Zustand des Verbindungsbereichs des Kühlkörpers (11) aufgrund thermischer Ausdehnung des Kühlkörpermaterials eine Presspassung entsteht, in deren Zuge die jeweilige Verbindungsfläche des Kühlkörpers (11) gegen die jeweils gegenüberliegende Verbindungsfläche des Anschlussteils (12) gedrückt wird.

3. Verfahren gemäß Anspruch 1 oder 2, **dadurch gekennzeichnet, dass** der Kühlkörper (11) ein Profilkörper ist mit einer ersten großflächigen Wandung, einer von dieser beabstandeten, zu dieser insbesondere parallel verlaufenden zweiten großflächigen Wandung, sowie zwei voneinander beabstandeten, die erste und die zweite großflächige Wandung jeweils miteinander verbindenden Schmalseitenwandungen, wobei die Verbindungsflächen des Kühlkörpers (11) (endständige) Bereiche der Außenseiten dieser Profilkörperwandungen sind.

4. Verfahren gemäß Anspruch 3, **dadurch gekennzeichnet, dass** durch ein jeweiliges Pressorgan diejenigen Verbindungsflächen des Anschlussteils (12) gegen die jeweils gegenüberliegende Verbindungsfläche des Kühlkörpers (11) gedrückt werden, die jeweils der ersten großflächigen Wandung bzw. der zweiten großflächigen Wandung gegenüberliegen, und/oder dass diejenigen Verbindungsflächen des Anschlussteils (12), die jeweils einer Verbindungsfläche einer der Schmalseitenwände des Kühlkörpers (11) gegenüberliegen, durch die Presspassung mit der jeweiligen Verbindungsfläche des Kühlkörpers (11) verbunden werden.

5. Verfahren gemäß Anspruch 4, **dadurch gekennzeichnet, dass** die Verbindungsflächen sämtlicher dieser Wandungen des Kühlkörpers (11) mit der jeweils gegenüberliegenden Verbindungsfläche des Anschlussteils (12) durch ein jeweiliges, die Verbindungsfläche des Anschlussteils (12) gegen die jeweilige Wandung drückendes Pressorgan verbunden werden.

6. Verfahren gemäß einem oder mehreren der vorhergehenden Ansprüche 1 - 5, **dadurch gekennzeichnet, dass** das Drücken der jeweiligen Verbindungsfläche des Anschlussteils (12) gegen die jeweils gegenüberliegende Verbindungsfläche des Kühlkörpers (11) mittels des jeweiligen Pressorgans erfolgt, indem dieses Druck auf diejenige Wandung der Aufnahme ausübt, an der die jeweilige Verbindungsfläche angeordnet ist, insbesondere auf die Außenseite dieser Wandung.

## Claims

1. Method for producing a cooling component, which has a cooling body (11) made of metal or a metal alloy, in particular aluminum, with which an object may be cooled, wherein the cooling body (11) has one or more, preferably parallel medium channels for the throughflow of cooling medium, and a connection part (12), which is connected to the cooling body (11) in a fluid-tight manner and via which the cooling medium can be supplied to the cooling body (11) and/or via which the cooling medium can be discharged from the cooling body (11), having the following measures:
a) inserting a, in particular terminal ,connecting region of a/the prefabricated cooling body (11), which is, in particular, produced by profile extrusion and, in particular, manufactured in one piece, into a receiving space of a receptacle of a/the prefabricated, in particular injection molded, plastic connection part (12) for the cooling body (11) via a relative movement between the cooling body (11) and the connection part (12), so that each of a plurality of, in particular mutually parallel opposing connecting faces of a connecting region of the cooling body (11), each with three-dimensional nanostructures and/or microstructures incorporated, in particular, by physical and/or chemical nanostructuring or microstructuring methods, is opposite a respectively associated connecting face of the receptacle of the connection part (12), in particular a respectively associated connecting face which is arranged on an inner side of a wall of the receptacle,
b) heating the connecting faces of the cooling body (11), in particular via induction, to a temperature which corresponds at least to a softening temperature or melting temperature of the plastic of the connection part (12), in particular before the connecting region of the cooling body (11) is inserted into the receiving space of the receptacle and/or while the connecting region is located in the receiving space,
c) connecting all heated connecting faces of the cooling body (11) to the respectively opposing connecting face of the connection part (12) in a fluid-tight manner by pressing these mutually opposing connecting faces together while melting the connecting face of the connection part (12) through the heat of the connecting face of the cooling body (11).

2. The method as claimed in claim 1, **characterized in that** all connecting faces of the cooling body (11), or only a pair of connecting faces of the cooling body (11), which are, in particular, opposite one another at a spacing, is/are pressed together with the respectively opposing connecting face of the connection part (12) **in that** a pressing member presses the respective connecting face of the connection part (12) against the respectively opposing connecting face of the cooling body (11) in each case and/or all connecting faces of the cooling body (11) or only a pair of, in particular, opposing connecting faces of the cooling body is/are pressed together with the respectively opposing connecting face of the connection part (12) in that the spacing of mutually opposing connecting faces of the cooling body (11) is matched to a spacing of mutually opposing connecting faces of the connection part (12) so that, by heating these connecting faces of the cooling body (11) in an inserted state of the connecting region of the cooling body (11) in the receiving space of the connection part (12), a thermal expansion of the cooling body (11) material results in a press fit, in the course of which the respective connecting face of the cooling body (11) is pressed against the respectively opposing connecting face of the connection part (12).

3. The method as claimed in claim 1 or 2, **characterized in that** the cooling body is a profile body (11) having a first large-surface wall, a second large-surface wall, which is spaced therefrom and extends, in particular, parallel thereto, and two mutually spaced narrow side walls connecting the first and the second large-surface wall to one another, wherein the connecting faces of the cooling body (11) are (terminal) regions of outer sides of these profile body walls.

4. The method as claimed in claim 3, **characterized in that** those connecting faces of the connection part (12) which are opposite the first large-surface wall or the second large-surface wall in each case are pressed against the respectively opposing connecting face of the cooling body (11) by a respective pressing member, and/or those connecting faces of the connection part (12) which are opposite a connecting face of one of the narrow side walls of the cooling body (11) in each case are connected to the respective connecting face of the cooling body (11) via the press fit.

5. The method as claimed in claim 4, **characterized in that** the connecting faces of all of these walls of the cooling body (11) are connected to the respectively opposing connecting face of the connection part (12) by a respective pressing member pressing the connecting face of the connection part against the respective wall.

6. The method as claimed in claim 1-5, **characterized in that** the pressing of the respective connecting face of the connection part (12) against the respectively opposing connecting face of the cooling body (11) takes place by means of the respective pressing member **in that** this applies pressure to the wall of the receptacle on which the respective connecting face is arranged, in particular to the outer side of this wall.

## Revendications

1. Procédé de fabrication d'un composant de refroidissement comportant un dissipateur thermique (11) en métal ou en alliage métallique, notamment en aluminium, permettant de refroidir un objet, le dissipateur thermique (11) comportant un ou plusieurs canaux de circulation, de préférence parallèles, destinés au passage d'un fluide de refroidissement, ainsi qu'une pièce de raccordement (12) reliée de manière étanche au fluide au dissipateur thermique (11), par l'intermédiaire de laquelle le fluide de refroidissement peut être amené au dissipateur thermique (11) et/ou par l'intermédiaire de laquelle le fluide de refroidissement peut être évacué du dissipateur thermique (11), comprenant les étapes suivantes :
a) insertion d'une zone de raccordement, notamment terminale, d'un dissipateur thermique (11) préfabriqué, notamment fabriqué par extrusion de profilés, notamment fabriqué d'un seul tenant, dans l'espace de réception d'un logement d'une pièce de raccordement (12) préfabriquée, notamment moulée par injection, en matière plastique pour le dissipateur thermique (11), au moyen d'un mouvement relatif entre le dissipateur thermique (11) et la pièce de raccordement (12), de telle sorte que chacune des différentes surfaces de raccordement de la zone de raccordement du dissipateur thermique (11) - qui sont notamment parallèles les unes aux autres - soit en regard d'une surface de raccordement respective du boîtier de la pièce de raccordement (12), qui a été pourvue, en particulier par des procédés de nanostructuration ou de microstructuration physiques et/ou chimiques, de nanostructures et/ou de microstructures tridimensionnelles, chacune correspondant à une surface de raccordement respective du logement de la pièce de raccordement (12), en particulier une surface de raccordement respective disposée sur une face interne d'une paroi du logement,
b) chauffage des surfaces de raccordement du dissipateur thermique (11), notamment par induction, à une température correspondant au moins à la température de ramollissement ou à la température de fusion de la matière plastique de la pièce de raccordement (12), notamment avant que la zone de raccordement du dissipateur thermique (11) ne soit introduite dans l'espace de logement du logement et/ou pendant que la zone de raccordement se trouve dans l'espace de logement,
c) assemblage étanche aux fluides de toutes les surfaces de raccordement chauffées du dissipateur thermique (11) avec la surface de raccordement respectivement opposée de la pièce de raccordement (12) par compression de ces surfaces de raccordement opposées, avec fusion de la surface de raccordement de la pièce de raccordement (12) sous l'effet de la chaleur de la surface de raccordement du dissipateur thermique (11).

2. Procédé selon la revendication 1, **caractérisé en ce que** toutes les surfaces de raccordement du dissipateur thermique (11) ou seulement une paire de surfaces de raccordement du dissipateur thermique (11) situées en face l'une de l'autre, notamment à distance l'une de l'autre, sont pressées contre la surface de raccordement correspondante de la pièce de raccordement (12), un organe de pression respectif pressant la surface de raccordement correspondante de la pièce de raccordement (12) contre la surface de raccordement respectivement opposée du dissipateur thermique (11), et/ou **en ce que** toutes les surfaces de raccordement du dissipateur thermique (11) ou seulement une paire de surfaces de raccordement du dissipateur thermique (11), en particulier opposées l'une à l'autre, sont pressées contre la surface de raccordement respectivement opposée de la pièce de raccordement (12) en ajustant la distance entre les surfaces de raccordement opposées du dissipateur thermique (11) à la distance entre les surfaces de raccordement opposées de la pièce de raccordement (12), de sorte que, par le réchauffement de ces surfaces de raccordement du dissipateur thermique (11) , dans l'état de la zone de raccordement du dissipateur thermique (11) introduit dans l'espace de réception de la pièce de raccordement (12), un ajustement serré se forme en raison de la dilatation thermique du matériau du dissipateur thermique, au cours duquel la surface de raccordement respective du dissipateur thermique (11) est pressée contre la surface de raccordement opposée respective de la pièce de raccordement (12).

3. Procédé selon la revendication 1 ou 2, **caractérisé en ce que** le dissipateur thermique (11) est un corps profilé comportant une première paroi de grande surface, une deuxième paroi de grande surface espacée de celle-ci et s'étendant notamment parallèlement à celle-ci, ainsi que deux parois latérales étroites espacées l'une de l'autre et reliant respectivement entre elles la première et la deuxième paroi de grande surface, les surfaces de raccordement du dissipateur thermique (11) sont des zones (d'extrémité) des faces extérieures de ces parois du corps profilé.

4. Procédé selon la revendication 3, **caractérisé en ce que**, à l'aide d'un organe de pression respectif, les surfaces de raccordement de la pièce de raccordement (12) qui sont respectivement situées en face de la première paroi de grande surface ou de la deuxième paroi de grande surface sont pressées contre la surface de raccordement respectivement opposée du dissipateur thermique (11), et/ou **en ce que** les surfaces de raccordement de la pièce de raccordement (12) qui sont respectivement en regard d'une surface de raccordement de l'une des parois latérales étroites du dissipateur thermique (11) sont reliées à la surface de raccordement correspondante du dissipateur thermique (11) par ajustement serré.

5. Procédé selon la revendication 4, **caractérisé en ce que** les surfaces de raccordement de toutes ces parois du dissipateur thermique (11) sont reliées à la surface de raccordement respectivement opposée de la pièce de raccordement (12) par un organe de pression respectif pressant la surface de raccordement de la pièce de raccordement (12) contre la paroi respective.

6. Procédé selon une ou plusieurs des revendications 1 à 5 précédentes, **caractérisé en ce que** la pression de la surface de raccordement respective de la pièce de raccordement (12) contre la surface de raccordement opposée respective du dissipateur thermique (11) s'effectue au moyen de l'organe de pression respectif, celui-ci exerçant une pression sur la paroi du logement sur laquelle est disposée la surface de raccordement respective, en particulier sur la face extérieure de cette paroi.
